# EUROPEAN PATENT APPLICATION

(11) **EP 1 393 896 A1**
(43) Date of publication of application: **03.03.2004**
(21) Application number: 02717134.7
(22) Date of filing: 12.04.2002
(51) Int. Cl.: B32B 27/16, B32B 27/00

(54) **LAMINATED PLATE AND PART USING THE LAMINATED PLATE**

(30) Priority: 20.04.2001 JP 2001123659; 13.06.2001 JP 2001177836
(71) Applicant: Toyo Kohan Co., Ltd., Tokyo 102-8447 (JP)
(72) Inventor: SAIJO, Kinji TOYO KOHAN CO., LTD., Kudamatsu-shi, Yamaguchi 744-8611 (JP); YOSHIDA, Kazuo TOYO KOHAN CO., LTD., Kudamatsu-shi, Yamaguchi 744-8611 (JP); OKAMOTO, Hiroaki TOYO KOHAN CO., LTD., Kudamatsu-shi, Yamaguchi 744-8611 (JP); OHSAWA, Shinji TOYO KOHAN CO., LTD., Kudamatsu-shi, Yamaguchi 744-8611 (JP)
(74) Representative: VOSSIUS & PARTNER
(86) International application number: PCT/JP2002/003677
(87) International publication number: WO 2002/085621

(57) **Abstract**

A laminated plate formed of a base material and a high molecular plate laminated with each other without using adhesive agent and a part using the laminated plate, wherein the laminated plate is formed by laminatedly sticking the base plate to the high molecular plate after applying an activating treatment onto the opposed surfaces of the base plate and the high molecular plate, and the part is formed by using the laminated plate.

## Description

### Technical Field

The present invention concerns a laminated plate formed by laminating a base material and a high molecular plate without using an adhesive agent and a part using the laminated plate.

### Background Art

Heretofore, various laminated plates formed by laminating plates such as made of high molecular materials to base materials such as printed wiring board have been proposed and a method of bonding by using adhesive agents has been proposed as the lamination method.

However, in the existent lamination method as described above, since the heat resistance of the adhesive agent is poor, it involves problems such that the heat resistance as the laminated plate is limited or the thickness and the weight are increased by so much as the layer of the adhesive agent and, accordingly, it is not suitable to the decrease of weight and reduction of thickness.

In view of the technical background as described above, it is a subject of the present invention to provide a laminated plate formed by laminating a base material and a high molecular plate with no deterioration of electrical characteristics caused by the adhesive agent layer and without using the adhesive agent, as well as parts, printed wiring boards and IC packages using the laminated plate.

### Disclosure of the Invention

A laminated plate described in claim 1 is a laminated plate formed by laminating a high molecular plate on at least one surface of a base material, wherein the laminated plate is formed by previously activating respective surfaces of the base material and the high molecular plate to be adhered to each other and then abutting and overlapping the base material and the high molecular plate such that the activation surfaces of the base material and the high molecular plate are opposed to each other thereby press bonding them. In this case, the activation treatment preferably comprises conducting electric discharge in an inert gas atmosphere and applying sputter etching to the respective surfaces of the base material and the high molecular plate.

Further, it is preferred that the base material is one of liquid crystal polymer, polyimide and glass epoxy and the high molecular plate is liquid crystal polymer or polyimide .

The part described in claim 4 is preferably a part using the laminated plate. Further, the part is preferably parts of printed wiring boards or IC packages.

### Brief Description of the Drawings

Fig. 1 is a schematic cross sectional view showing an embodiment of a laminated plate according to the present invention.
Fig. 2 is a schematic cross sectional view showing another embodiment of a laminated plate according to the present invention.

### Best Mode for Practicing the Invention

Embodiments of the present invention are to be described below.

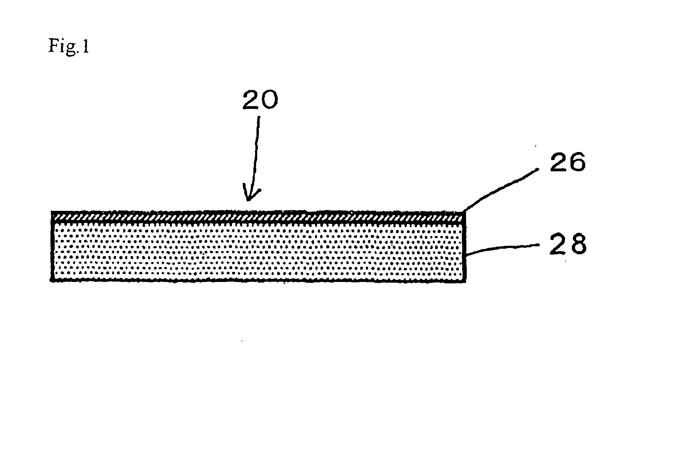

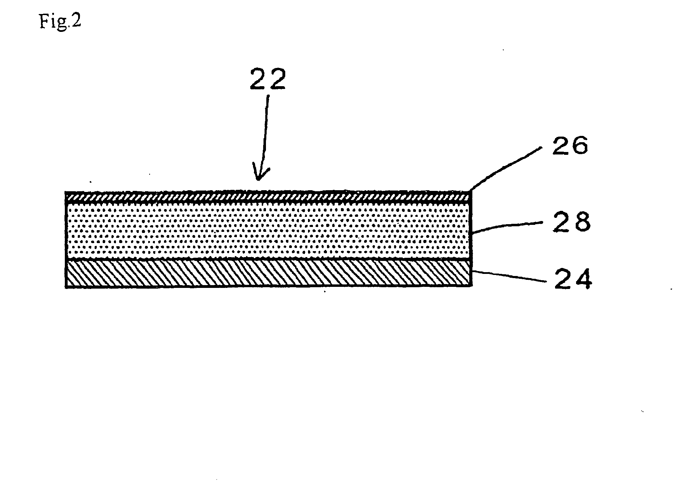

Fig. 1 is a schematic cross sectional view showing an embodiment of a laminated plate according to the present invention, which shows an example of laminating a high molecular plate 26 on one surface of a base material 28. Fig. 2 is a schematic cross sectional view showing another embodiment of a laminated plate according to the present invention, which shows an example of laminating a high molecular plate 24, 26 on both surfaces of a base material 28.

As the material for the high molecular plate 26, a liquid crystal polymer or polyimide is used. For the polyimide, both usual material and thermoplastic type material can be used. Further, the thickness of the high molecular plate 26 is also selected properly depending on the application use of the laminated plate. It is, for example, from 1 to 1000 µm. In a case where it is less than 1 µm, preparation as the high molecular plate is difficult. When it exceeds 1000 µm, preparation as the laminated plate is difficult. In a case where the application use of the laminated plate is a flexible printed substrate, those within a range, for example, from 3 to 300 µm are applied. In a case where it is less 3 µm, mechanical strength is poor and in a case where it exceeds 300 µm, flexibility is poor. It is preferably from 10 to 150 µm and, more preferably, 20 to 75 µm.

As the material for the high molecular plate 24, any material applicable to the high molecular material 26 can be selected and the material and the thickness for the high molecular plate 24 may be identical with or different from those of high molecular plate 26.

The kind of the base material 28 has no particular restriction so long as it is a material comprising metal, inorganic material or organic material capable of preparing the laminated plate and can be properly selected and used depending on the application use of the laminated plate. For example, this is high molecular plate, rigid printed wiring board or flexible printed wiring board. In a case where the substrate material is high molecular plate, those applicable for the high molecular plate 26 can be selected, and the material and the thickness of the base material may be identical with or different from those for the high molecular plate 24 to be laminated. In a case where the base material is a printed wiring board, those having no protection film for the surface layer, with the wiring portion being exposed may also be used. Further, for the printed wiring board, a paper epoxy substrate, glass epoxy substrate, ceramic substrate, etc. may be used.

A method of manufacturing a laminated plate shown in Fig. 1 is to be described. A high molecular plate 26 and a base material 28 each cut into a predetermined size are located in a manufacturing apparatus and they are applied with an activation treatment respectively by an activation treatment device.

The activation treatment is conducted as described below. That is, the high molecular plate 26 and the base material 28 loaded in the manufacturing apparatus are brought into contact respectively with one electrode A grounded to the earth and subjected to sputter etching treatment by applying an AC current at 1 to 50 MHz relative to another electrode B supported in an insulated manner in an inert gas atmosphere, preferably, an argon gas at about atmospheric pressure, to conduct glow discharge or corona discharge, with the area for each of the high molecular plate 26 and the base material 28 in contact with the electrode A exposed to the plasmas caused by discharge being 1/3 or less for the area of the electrode B. The inert gas can be applied at a pressure within a range exceeding 9 x 10⁴ and up to about atmospheric pressure. For the AC current applied, it is difficult to keep stable discharge and continuous etching is difficult in a case where it is less than 1 MHz, whereas oscillation tends to occur and the power supply system is complicated in a case where it exceeds 50 MHz, which is not preferred. Further, for etching at a good efficiency, it is necessary that the area for the electrode A is made smaller than the area for the electrode B and etching is possible at a sufficient efficiency by defining it to 1/3 or less.

Then, the high molecular plate 26 and the base material 28 applied with the activation treatment are abutted and overlapped to each other such that the activated surfaces are opposed to each other and hot press-bonded by a press bonding unit and laminated and bonded. Assuming the heating temperature as T (°C), and the melting temperature as Tm (°C), T < Tm is preferred. Particularly for the material having a glass transition point, for example, liquid crystal polymer or the like, Tg < T < Tm is preferred, assuming the glass transition temperature as Tg (°C). It is, more preferably, Tg+20 < T < Tm-20. By lamination bonding as described above, the laminated plate 20 is formed and the laminated plate 20 shown in Fig. 1 is manufactured.

Then, a laminated plate 22 shown in Fig. 2 is manufactured in the same manner by using a laminated plate 20 instead of the base material 28 in the foregoing description.

The thus manufactured laminated plate may be applied with a heat treatment for removing or reducing residual stress as required. In the heat treatment, since deleterious gas which may cause lowering of the bonding strength (for example, oxygen) may possibly permeate a high molecular plate, it is preferably conducted in vacuum or in a reduced pressure state, or in a reducing atmosphere.

For the manufacture of the laminated plate, a batchwise treatment may be adopted. An activation treatment is conducted while loading a plurality of high molecular plates and base materials each cut into a predetermined size previously in the manufacturing apparatus, conveying them to the activation treatment device and locating or gripping them in a state where surfaces to be treated are opposed or set in parallel with each other to an appropriate position such as vertical or horizontal state, applying press bonding while locating or gripping them as they are after the activation treatment in a case where the device for holding the high molecular plate and the base material also serves as a press bonding device, or conveying them to a press bonding device such as a pressing device and conducting press bonding in a case where the device for holding the high molecular plate or the base material does not serve as the press bonding device.

In a case where a printed wiring board is used as a base material for the laminated plate of the present invention, a circuit pattern may be formed to the high molecular plate, applied with through holes or interlayer conduction fabrication to constitute the circuit into a multi-layered structure, and a further multi-layered printed wirings board can be obtained by using the multi-layered laminated plate as a base material. Furthermore, a high molecular plate previously formed with a circuit pattern or laminated with a conductive plate such as made of metal may be laminated to the base material. Accordingly, it is suitable to printed wiring boards (rigid printed wiring boards or flexible printed wiring boards) and is applicable also IC packages for IC card, CSP (chip size packages or chip scale packages), BGA (ball grid arrays), etc.

### Example

Examples are to be described below

### (Example 1)

A liquid crystal polymer film of 50 µm thickness was used as a high molecular plate 26, and a liquid crystal polymer film of 50 µm thickness was used as a substrate material 28. Both of the liquid crystal polymer films were set in a laminated plate manufacturing apparatus and the liquid crystal polymer films were subjected to an activation treatment respectively in a activation treatment unit (argon gas atmosphere, 10⁻³ - 4 x 10⁻³ Pa) by a sputter etching method. Then, the activated liquid crystal polymer films were stacked to each other with the activated surfaces being abutted against each other in a press bonding device to manufacture a laminated plate 20.

### (Example 2)

A liquid crystal polymer film of 50 µm thickness was used as a high molecular plate 26, and a polyimide film of 50 µm thickness was used as a base material 28. The liquid crystal polymer film and the polyimide film were set in a laminated plate manufacturing apparatus and the liquid crystal polymer film and the polyimide film were subjected to an activation treatment respectively in an activation treatment unit (argon gas atmosphere, 10⁻² - 4 x 10⁻² Pa) by a sputter etching method. Then, the activated liquid crystal polymer film and the polyimide film were stacked to each other with the activated surfaces being abutted against to each other in a press bonding device to manufacture a laminated plate 20.

### (Example 3)

A liquid crystal polymer film of 50 µm thickness on which a copper foil of 18 µm thickness was laminated to form a circuit was used for a base material 28, and a laminated material formed by laminating a copper foil of 18 µm thickness on a liquid crystal polymer film of 50 µm thickness was used instead of the high molecular plate 26. The base material and the laminated material were set in a laminated plate manufacturing apparatus, and the base material on the side formed with the circuit and the laminated material on the side of the liquid crystal polymer film were applied with activation treatment respectively in an activation treatment unit (argon gas atmosphere, 10⁻¹ - 10 Pa) by a sputter etching method. Then, the base material on the side formed with the circuit and the laminated material on the side of the liquid crystal polymer film, which were put to an activation treatment were stacked and press bonded in a state of abutting the activated surfaces against each other by a press bonding device to manufacture a laminated plate 20. Then, through hole fabrication, conduction fabrication by plating and circuit formation for the surface layer were conducted to manufacture a circuit substrate.

### Industrial Applicability

As has been described above, the laminated plate according to the present invention is formed by applying an activation treatment to the surfaces of the base material and the high molecular plate opposed to each other and then abutting and stacking them such that the activated surfaces are opposed to each other and press bonding them. Accordingly, no adhesive agent is used, more reduction in the weight and reduction in the thickness can be attained and it is suitable to application use for circuit substrate, etc.

## Claims

1. A laminated plate formed by laminating a high molecular plate on at least one surface of a base material wherein the surfaces of the base material and the high molecular plate to be bonded are previously applied with an activation treatment and then the base material and the high molecular plate are abutted and stacked against each other such that the activated surfaces thereof are opposed to each other and press bonding them.

2. A laminated plate according to claim 1, wherein the activation treatment comprises conducting electric discharge in an inert gas atmosphere and applying a sputter etching treatment to each of the surfaces of the base material and the high molecular plate.

3. A laminated plate according to claim 1 or 2, wherein the base material comprises one of liquid crystal polymer, polyimide and glass epoxy, and the high molecular plate comprises liquid crystal polymer or polyimide.

4. A part using a laminated plate as described in claim 1 or 2.

5. A part according to claim 4 wherein the part is a printed wiring board.

6. A part according to claim 5 wherein the part is an IC package.
